# EUROPÄISCHE PATENTSCHRIFT

(11) **EP 2 982 227 B1**
(45) Veröffentlichungstag und Bekanntmachung des Hinweises auf die Patenterteilung: **01.04.2020**
(21) Anmeldenummer: 14728817.9
(22) Anmeldetag: 01.04.2014
(51) Int. Cl.: H05K 5/06, H01F 27/02, H01F 41/12, B29C 45/14

(54) **VERFAHREN UND VORRICHTUNG ZUR HERSTELLUNG EINER ABDICHTUNG ZWISCHEN EINEM TRÄGER EINES ELEKTRISCHEN BAUTEILS UND EINER DEN TRÄGER ZUMINDEST TEILWEISE UMGEBENDEN UMSPRITZUNG**
APPARATUS FOR SEALING BETWEEN A SUPPORT FOR AN ELECTRIC COMPONENT AND AN OVERMOULDING; METHOD AND APPARATUS FOR CREATING A SEAL BETWEEN A SUPPORT FOR AN ELECTRIC COMPONENT AND AN OVERMOULDING
PROCÉDÉ ET DISPOSITIF DE FABRICATION D'UN SYSTÈME D'ÉTANCHÉITÉ ENTRE UN SUPPORT D'UN COMPOSANT ÉLECTRIQUE ET UNE ENVELOPPE

(30) Priorität: 02.04.2013 DE 102013005485
(43) Veröffentlichungstag der Anmeldung: 10.02.2016
(73) Patentinhaber: Eugen Forschner GmbH, 78549 Spaichingen (DE)
(72) Erfinder: GROTZ, Michael, 78549 Spaichingen (DE)
(74) Vertreter: Wiese, Gerhard
(86) Internationale Anmeldenummer: PCT/DE2014/100113
(87) Internationale Veröffentlichungsnummer: WO 2014/161532

(56) Entgegenhaltungen:
- EP-A1- 2 226 185
- EP-A2- 1 614 518
- EP-A2- 2 124 234
- DE-A1- 3 642 246

## Beschreibung

Die Erfindung betrifft ein Verfahren zur Herstellung einer Abdichtung zwischen einem Träger eines elektrischen Bauteils und einer den Träger zumindest teilweise umgebenden Umspritzung aus Kunststoff gemäß Anspruch 1 und eine Vorrichtung zur Herstellung einer Abdichtung zwischen einem Träger eines elektrischen Bauteils und einer den Träger zumindest teilweise umgebenden Umspritzung aus Kunststoff gemäß Anspruch 2, insbesondere zwischen einer Spule und einer Umspritzung.

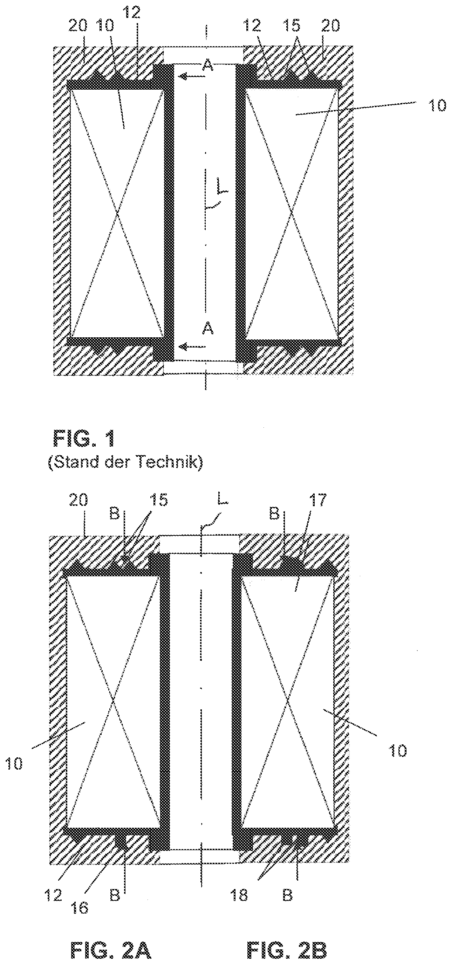

Aus der DE 10 2007 052 224 A1 ist eine Abdichtung bekannt, bei der an einem Spulenträger außen liegend Schmelzrippen angebracht sind, die beim Umspritzen des Spulenträgers mit einem Kunststoffmaterial aufschmelzen und dadurch eine dichtende Verbindung zwischen dem Spulenträger und der Umspritzung herstellen sollen. Diese Art der Abdichtung hat sich insbesondere für Spulen, die einem salzigen Spritzwasser ausgesetzt sind - beispielsweise bei solchen Spulen, wie sie bei Fahrwerksregelungen in Kraftfahrzeugen zum Einsatz kommen - als nicht dauerhaft dicht erwiesen. Dieser Stand der Technik ist schematisch in Fig. 1 dargestellt.

Ferner ist aus der DE 20 2011 052 516 A1 eine Spule in einem Elektromagnetventil bekannt, bei der zur Erzeugung einer Abdichtung zwischen einem Spulenträger und einem Anschlussgehäuse gemäß einer Ausführungsform nachträglich Laserschweißnähte außen liegend eingebracht werden.

Aus der EP 2 226 185 A1 ist ein Verfahren zur Herstellung einer Abdichtung zwischen einem Träger eines elektrischen Bauteils und einer den Träger zumindest teilweise umgebenden Umspritzung aus Kunststoff bekannt, wobei der Träger zumindest einen der Umspritzung zugewandten Vorsprung aufweist und wobei der Träger im Bereich des wenigstens einen Vorsprungs durch eine Laserschweißvorrichtung in einen flüssigen oder schmelzförmigen Zustand gebracht werden kann.

Ferner ist aus der EP 1 614 518 A2 eine Vorrichtung zur Abdichtung zwischen einem Träger eines elektrischen Bauteils und einer den Träger zumindest teilweise umgebenden Umspritzung aus Kunststoff bekannt, wobei der Träger zumindest einen der Umspritzung zugewandten Vorsprung aufweist und wobei die Vorrichtung eine dichte stoffschlüssige Verbindung zwischen dem Träger und der Umspritzung aufweist, die durch ein teilweises Schmelzen der Vorsprünge mittels eines Energieeintrags entsteht.

Aufgabe der Erfindung ist die Angabe eines Verfahrens und einer Vorrichtung zur Erzeugung einer verbesserten Abdichtung zwischen einem Träger eines elektrischen Bauteils und einer den Träger zumindest teilweise umgebenden Kunststoff-Umspritzung.

Diese Aufgabe wird hinsichtlich des Verfahrens durch die Merkmale des Anspruchs 1 gelöst. Eine verbesserte Vorrichtung ist im Anspruch 2 angegeben. Vorteilhafte Ausgestaltungen der Erfindung sind in den Unteransprüchen angegeben.

Die erfinderische Lösung sieht vor, dass die Vorrichtung eine dichte, stoffschlüssige Verbindung zwischen dem Träger und der Umspritzung aufweist, die durch eine Energieeinwirkung in axialer Richtung bezogen auf die Längsachse des Bauteils in Richtung auf den wenigstens einen Vorsprung gebildet wird. Die Energieeinwirkung erfolgt unmittelbar vor dem Aufbringen der Umspritzung mit Hilfe eines im Werkzeug oder in wenigstens einem von mehreren Werkzeugteilen bewegbar gelagerten Hilfswerkzeuges, wobei das Hilfswerkzeug von einer Laserschweißvorrichtung oder einer Heißgasschweißvorrichtung gebildet wird.

Durch diese Vorrichtung ist eine prozesssichere, dauerhaft dichte Verbindung gewährleistet. Aufgrund der axialen Energieeinwirkung lässt sich ein höherer Druck aufbauen, wobei wenigstens ein umlaufender, rippenförmiger Vorsprung zusätzlich für eine vergrößerte Verbindungsfläche zwischen dem Träger und der Umspritzung sorgt. Der Vorsprung kann bevorzugt einen dreieckigen, einen rechteckigen, einen trapezförmigen oder einen halbrunden Querschnitt aufweisen. Gut geeignet ist eine Anordnung aus zwei in geringem Abstand parallel zueinander angeordneten Vorsprüngen, bei denen die Energieeinwirkung insbesondere auf den Zwischenraum zwischen den Vorsprüngen gerichtet ist.

Die Vorrichtung ist derart ausgebildet, dass die Energieeinwirkung mittels Laserschweißen oder Heißgasschweißen erfolgt. Beim Laserschweißen kann ein Druck zusätzlich durch eine für die Laserstrahlen durchlässige Glasdruckplatte erzeugt werden.

Alternativ zu einer klassischen Umspritzung kann auch ein Makromelt-Verfahren oder ein Hotmelt-Verfahren in Form von thermoplastischen oder reaktiven (PUR-) Hotmelts zum Einsatz kommen. Bei den Vergusswerkstoffen des Makromelt-Verfahrens handelt es sich um thermoplastische Schmelzklebstoffe auf Basis von Polyamid. Mittels dieser Verfahren kann ebenfalls eine "Umspritzung" im Sinne dieser Erfindung erzeugt werden.

Ein erfindungsgemäßes Verfahren zeichnet sich dadurch aus, dass der Träger im Bereich des wenigstens einen Vorsprungs durch eine Energieeinwirkung und/oder Druckeinwirkung in einen flüssigen oder schmelzförmigen Zustand gebracht wird.

Dies erfolgt unmittelbar vor dem Aufbringen der UmspritzungDer wenigstens eine Düsenkanal zur Einspeisung des Heißgases der Heißgasschweißvorrichtung ist bevorzugt mittels eines Verschlusselements verschließbar, so dass der Düsenkanal beim Einbringen der Umspritzung gegenüber dem einschießenden Kunststoffmaterial abgedichtet ist und nicht verklebt.

Nachfolgend wird ein Ausführungsbeispiel einer erfindungsgemäßen Vorrichtung unter Bezugnahme auf die Zeichnungen näher erläutert. Dabei bezeichnen gleiche Bezugszeichen in den verschiedenen Figuren die gleichen Elemente. Es zeigt:
- Fig. 1: eine schematische Ansicht einer Ausführungsform gemäß dem Stand der Technik;
- Fig. 2A: eine schematische Ansicht einer ersten und zweiten Ausführungsform (in der oberen und in der unteren linken Bildhälfte) einer erfindungsgemäßen Vorrichtung zur Abdichtung,
- Fig. 2B: eine schematische Ansicht einer dritten und vierten Ausführungsform (in der oberen und in der unteren rechten Bildhälfte) einer erfindungsgemäßen Vorrichtung zur Abdichtung,
- Fig. 3: eine schematische Ansicht einer fünften und sechsten Ausführungsform (in der oberen und in der unteren Bildhälfte) einer erfindungsgemäßen nur zur Hälfte dargestellten Vorrichtung zur Abdichtung mit einer schematisch angedeuteten Vorrichtung zur Herstellung,
- Fig. 4: eine schematische Ansicht einer siebten Ausführungsform einer erfindungsgemäßen nur zur Hälfte dargestellten Vorrichtung zur Abdichtung mit einer schematisch angedeuteten Vorrichtung zur Herstellung, und
- Fig. 5: eine schematische Ansicht einer achten Ausführungsform einer erfindungsgemäßen nur zur Hälfte dargestellten Vorrichtung zur Abdichtung mit einer schematisch angedeuteten Vorrichtung zur Herstellung.

In Figur 1 ist eine aus der DE 10 2007 052 224 A1 bekannte Abdichtung bekannt. Dabei sind an einem Träger 12 eines bevorzugt als Spule ausgebildeten elektrischen Bauteils 10 nach außen vorspringende, umlaufende rippenförmige Vorsprünge 15 angeordnet, die beim Erzeugen der Umspritzung 20 aufschmelzen und dadurch mit dem Kunststoff der Umspritzung 20 eine dichte Verbindung eingehen sollen. In der Praxis zeigt sich jedoch, dass der Kunststoff der Umspritzung 20 beim Einspritzen in ein Werkzeug relativ schnell an Energie verliert, so dass die Vorsprünge 15 in Teilbereichen des Umfangs häufig nur unzureichend aufschmelzen und somit keine dauerhafte Dichtigkeit erreicht wird.

Für Abhilfe sorgen erfindungsgemäße Vorrichtungen gemäß den Figuren 2 bis 5, denen gemeinsam ist, dass bei Ihnen durch eine Energie- und/oder Druckeinwirkung eine dichte, stoffschlüssige Verbindung zwischen dem Träger 12 und der Umspritzung 20 erzeugt wird.

Bei den Ausführungsformen gemäß den Figuren 2A und 2B, die sich durch unterschiedliche Formen der rippenartigen Vorsprünge unterscheiden, erfolgt die axiale Energie- und/oder Druckeinwirkung bevorzugt durch eine Laserschweißvorrichtung, die in Richtung der Pfeile "B", also parallel zur Längsachse "L" des Bauteils 10, auf die Außenwand des Trägers 12 und die dort angeordneten Vorsprünge 15, 16, 17 oder 18 einwirkt. Im oberen Teil der Figur 2A sind Vorsprünge 15 mit dreieckförmigem Querschnitt dargestellt. Im unteren Teil der Figur 2A sind Vorsprünge 16 mit rechteckförmigem Querschnitt dargestellt. Vorsprünge 17 mit halbrundem Querschnitt sind in der oberen Hälfte der Figur 2B gezeigt. Zwei parallel angeordnete, geringfügig voneinander beabstandet verlaufende Vorsprünge 18 sind in der unteren Hälfte der Figur 2B dargestellt.

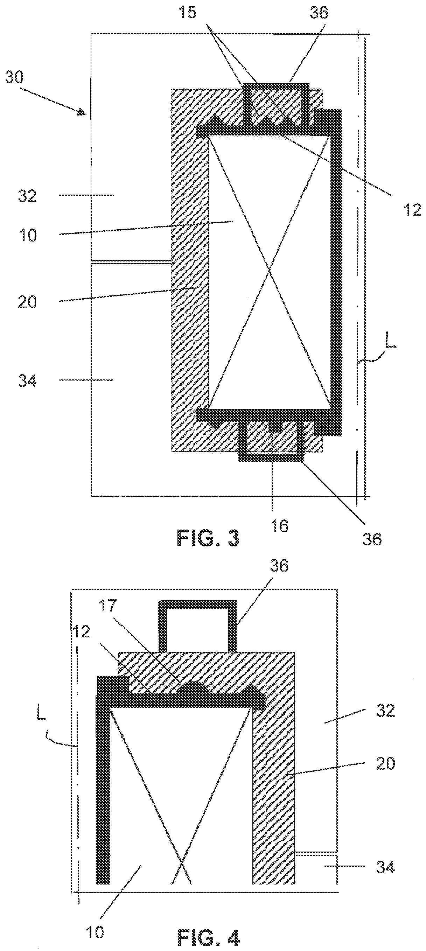

In der Ausführungsform gemäß Figur 3 und 4 kommt in einem aus zwei Werkzeughälften 32 und 34 bestehenden Formwerkzeug 30 ein Hilfswerkzeug 36 zum Einsatz, das wie eine Haube ausgebildet ist und als Heißgasschweißvorrichtung in einem in die Kavität für den später eingebrachten Kunststoff der Umspritzung 20 eingefahrenen Zustand (gemäß Figur 3) die Außenwand des Trägers 12 im Bereich der Vorsprünge 15 (oberer Teil der Fig. 3) oder 16 (unterer Teil der Fig. 3) anschmilzt. Anschließend wird das Hilfswerkzeug 36 aus der Kavität ins Werkzeug 30 zurückgezogen (Fig. 4) und der Kunststoff der Umspritzung 20 in die Kavität eingebracht. Aufgrund der kurz davor erfolgten Erhitzung der Vorsprünge 15 bzw. 16 und/oder benachbarter Bereiche ist der Kunststoff der Umspritzung 20 in der Lage, eine dichte materialschlüssige Verbindung mit dem Kunststoff des Trägers 12 einzugehen.

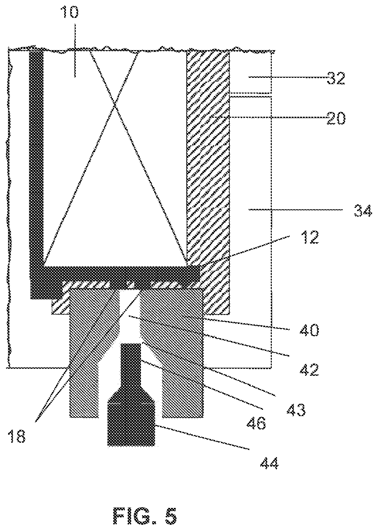

In der Ausführungsform gemäß Figur 5 wird das Hilfswerkzeug 40 von einer anderen Heißgasschweißvorrichtung gebildet. Diese kann gemäß der Darstellung in Figur 5 in ihrer Betriebsstellung an zwei im Querschnitt rechteckförmige rippenartige Vorsprünge 18 angestellt werden und durch Einspreisung von Heißgas durch den Düsenkanal 42 die Vorsprünge 18 und deren Zwischenraum erhitzen und anschmelzen. Das Hilfswerkzweug 40 wird dann zurückgezogen, wobei sich eine konische Dichtfläche eines im Hilfswerkzeug 40 bewegbaren Kolbens 44 an eine konische Dichtfläche 43 anlegt, die sich an das innere Ende des Düsenkanals 42 anschließt. Gleichzeit verschließt ein Stößel-förmiges Verschlusselement 46, das an der Vorderseite des Kolbens 44 angeordnet ist, den Düsenkanal 42 vollständig. Das Hilfswerkzeug 40 bildet in zurückgezogenem Zustand in Verbindung mit der Stirnfläche des Verschlusselements 46 einen bündigen Bestandteil des die Kavität für die Umspritzung 20 begrenzenden Teils 34 des Werkzeugs 30.

Die Erfindung ist allgemein für eine verbesserte Abdichtung eines aus Kunststoff bestehenden Trägers oder Gehäuses eines elektrischen oder elektronischen Bauteils gegenüber einer Umspritzung geeignet. Besonders bevorzugt wird die Erfindung für die verbesserte Abdichtung einer Spule verwendet, die im Spritzwasserbereich eines Fahrzeugs eingesetzt wird.

### Bezugszeichenliste

- 10: Bauteil (Spule)
- 12: Träger
- 15: Vorsprung (dreieckig)
- 16: Vorsprung (rechteckig)
- 17: Vorsprung (halbrund)
- 18: Vorsprünge (rechteckförmige)
- 20: Umspritzung
- 30: Form (Werkzeug)
- 32: erste Formhälfte (von 30)
- 34: zweite Formhälfte (von 30)
- 36: Hilfswerkzeug
- 40: Hilfswerkzeug
- 42: Düsenkanal
- 43: Dichtsitz
- 44: Kolben
- 46: Verschlusselement
- B: Axialschweißung
- L: Längsachse (von 10 und 12)

## Patentansprüche

1. Verfahren zur Herstellung einer Abdichtung zwischen einem Träger (12) eines elektrischen Bauteils (10) und einer den Träger (12) zumindest teilweise umgebenden Umspritzung (20) aus Kunststoff, wobei der Träger (12) in ein Werkzeug (30) eingelegt wird, das eine Kavität zur Einbringung des Kunststoff-Materials zur Bildung der Umspritzung (20 aufweist, wobei der Träger (12) zumindest einen der Umspritzung zugewandten Vorsprung (15, 16, 17, 18) aufweist, wobei der Träger (12) im Bereich des wenigstens einen Vorsprungs (15, 16, 17, 18) unmittelbar vor dem Aufbringen der Umspritzung (20) mit Hilfe eines im Werkzeug (30) oder in wenigstens einem von mehreren Werkzeugteilen (32, 34) bewegbar gelagerten Hilfswerkzeuges (36; 40) durch eine bezogen auf die Längsachse des Bauteils (10) axiale Energieeinwirkung und/oder Druckeinwirkung in einen flüssigen oder schmelzförmigen Zustand gebracht wird, wobei das Hilfswerkzeug von einer Laserschweißvorrichtung (36) oder einer Heißgasschweißvorrichtung (40) gebildet wird.

2. Vorrichtung zur Herstellung einer Abdichtung zwischen einem Träger (12) eines elektrischen Bauteils (10) und einer den Träger (12) zumindest teilweise umgebenden Umspritzung (20) aus Kunststoff, wobei die Vorrichtung ein Werkzeug (30) umfasst, in das der Träger (12) eingelegt werden kann und das eine Kavität zur Einbringung des Kunststoff-Materials zur Bildung der Umspritzung (20) aufweist, wobei im Werkzeug (30) oder in wenigstens einem von mehreren Werkzeugteilen (32, 34) wenigstens ein bewegbar gelagertes Hilfswerkzeug (36; 40) angeordnet ist, das von einer Laserschweißvorrichtung (36) oder einer Heißgasschweißvorrichtung (40) gebildet wird, und wobei der Träger (12) so in das Werkzeug (30) einlegbar ist, dass durch das Hilfswerkzeug (36; 40) parallel zu der Längsachse (L) des Bauteils (10) unmittelbar vor dem Aufbringen der Umspritzung (20) eine axiale Energie- und/oder Druckeinwirkung im Bereich eines auf einer Außenwand des Trägers (12) angeordneten Vorsprungs (15, 16, 17, 18) erfolgen kann.

3. Vorrichtung nach Anspruch 2, **dadurch gekennzeichnet, dass** die Heißgasschweißvorrichtung (40) wenigstens ein Verschlusselement (46) zum Verschließen wenigstens eines Düsenkanals (42) aufweist.

## Claims

1. Method for producing a seal between a support (12) of an electrical component (10) and a plastics insert-molding (20) that surrounds the support (12) at least in part, wherein the support (12) is placed in a mold (30) that comprises a cavity for introducing plastics material for forming the insert-molding (20), wherein the support (12) comprises at least one projection (15, 16, 17, 18) facing the insert-molding, wherein the support (12) is brought into a liquid or melt-like state in the region of the at least one projection (15, 16, 17, 18) by the action of energy and/or pressure, which is axial based on the longitudinal axis of the component (10), immediately before the insert-molding (20) is applied, with the aid of an auxiliary mold (36; 40) which is movably mounted in the mold (30) or in at least one of several mold parts (32, 34), wherein the auxiliary mold is formed by a laser-welding device (36) or a hot-gas welding device (40).

2. Device for producing a seal between a support (12) of an electrical component (10) and a plastics insert-molding (20) that surrounds the support (12) at least in part, wherein the device comprises a mold (30) in which the support (12) can be placed and which comprises a cavity for introducing the plastics material for forming the insert-molding (20), wherein at least one movably mounted auxiliary mold (36; 40) is arranged in the mold (30) or in at least one of several mold parts (32, 34), which auxiliary mold is formed by a laser-welding device (36) or a hot-gas welding device (40), and wherein the support (12) can be placed in the mold (30) such that an axial action of energy and/or pressure can take place in the region of a projection (15, 16, 17, 18), arranged on an outer wall of the support (12), by means of the auxiliary mold (36; 40), in parallel with the longitudinal axis (L) of the component (10), immediately before the insert-molding (20) is applied.

3. Device according to claim 2, **characterized in that** the hot-gas welding device (40) comprises at least one closure element (46) for closing at least one nozzle channel (42).

## Revendications

1. Procédé de réalisation d'une étanchéité entre un support (12) d'un composant électrique (10) et une enveloppe (20) en matière plastique entourant au moins partiellement le support (12), le support (12) étant inséré dans un outil (30) présentant une cavité pour l'acheminement du matériau plastique afin de former l'enveloppe (20), le support (12) présentant au moins une saillie (15, 16, 17, 18) orientée vers l'enveloppe, le support (12) dans la zone de l'au moins une saillie (15, 16, 17, 18) étant porté, immédiatement avant l'application de l'enveloppe (20) à l'aide d'un outil auxiliaire (36 ; 40) monté mobile dans l'outil (30) ou dans au moins l'une de la pluralité des parties d'outil (32, 34), à l'état liquide ou fondu par application axiale d'énergie et/ou de pression par rapport à l'axe longitudinal du composant (10), l'outil auxiliaire étant constitué d'un dispositif de soudage au laser (36) ou d'un dispositif de soudage au gaz chaud (40).

2. Dispositif permettant de réaliser une étanchéité entre un support (12) d'un composant électrique (10) et une enveloppe (20) en matière plastique entourant au moins partiellement le support (12), le dispositif comprenant un outil (30) dans lequel le support (12) peut être inséré, et présente une cavité pour l'acheminement du matériau plastique afin de former l'enveloppe (20), au moins un outil auxiliaire (36 ; 40) monté mobile dans l'outil (30) ou dans au moins l'une de la pluralité des parties d'outil (32, 34) étant prévu, lequel est constitué par un dispositif de soudage au laser (36) ou un dispositif de soudage au gaz chaud (40), et le support (12) pouvant être inséré dans l'outil (30) de telle manière qu'une application axiale d'énergie et/ou de pression dans la zone d'une saillie (15, 16, 17, 18) prévue sur une paroi extérieure du support (12) soit réalisée par l'outil auxiliaire (36 ; 40), immédiatement avant l'application de l'enveloppe (20), parallèlement à l'axe longitudinal (L) du composant (10).

3. Dispositif selon la revendication 2, **caractérisé en ce que** le dispositif de soudage au gaz chaud (40) présente au moins un élément de fermeture (46) permettant de fermer au moins un canal de buse (42).
